# EUROPEAN PATENT SPECIFICATION

(11) **EP 2 057 661 B1**
(45) Date of publication and mention of the grant of the patent: **26.10.2011**
(21) Application number: 07801508.8
(22) Date of filing: 03.08.2007
(51) Int. Cl.: H01J 37/32, C23C 14/22, B23B 51/02

(54) **APPARATUS FOR THE MODIFICATION OF SURFACES**
VORRICHTUNG ZUR VERÄNDERUNG VON OBERFLÄCHEN
APPAREIL POUR LA MODIFICATION DE SURFACES

(30) Priority: 03.08.2006 EP 06016249
(43) Date of publication of application: 13.05.2009
(73) Proprietor: Creepservice S.à.r.l., 2014 Bôle (CH)
(72) Inventor: CHIZIK, Anna Andreyevna, 2014 Bôle (CH); MIKHAILOV, Alexei Sergueievitch, 2014 Bôle (CH)
(74) Representative: Stolmár, Matthias
(86) International application number: PCT/EP2007/006892
(87) International publication number: WO 2008/015016

(56) References cited:
- WO-A-03/087425
- US-A- 5 599 144
- US-A1- 2002 007 796
- US-A1- 2005 117 257
- SCHULTRICH B ET AL: "Neuere Entwicklungen auf dem Gebiet der Vakuumbogenbeschichtung" VAKUUM IN FORSCHUNG UND PRAXIS, vol. 10, no. 1, 1998, pages 37-46, XP002417792 Weinheim, [DE]
- LOSSY R ET AL: "FILTERED ARC DEPOSITION OF AMORPHOUS DIAMOND" APPLIED PHYSICS LETTERS, AIP, AMERICAN INSTITUTE OF PHYSICS, MELVILLE, NY, US, vol. 61, no. 2, 13 July 1992 (1992-07-13), pages 171-173, XP000280682 ISSN: 0003-6951
- LEU M-S ET AL: "Diamond-like coatings prepared by the filtered cathodic arc technique for minting application" SURFACE & COATINGS TECHNOLOGY ELSEVIER SWITZERLAND, vol. 177-178, 30 January 2004 (2004-01-30), pages 566-572, XP002417791 ISSN: 0257-8972
- FAN Q H ET AL: "Diamond coating on steel with a titanium interlayer" DIAMOND AND RELATED MATERIALS, ELSEVIER SCIENCE PUBLISHERS, AMSTERDAM, NL, vol. 7, no. 2-5, February 1998 (1998-02), pages 603-606, XP004115114 ISSN: 0925-9635
- MATHIOUDAKIS C ET AL: "Nanomechanical properties of multilayered amorphous carbon structures" PHYSICAL REVIEW B (CONDENSED MATTER AND MATERIALS PHYSICS) APS THROUGH AIP USA, vol. 65, no. 20, 15 May 2002 (2002-05-15), pages 205203/1-14, XP002458383 ISSN: 0163-1829
- MAO D S ET AL: "ENHANCED ELECTRON FIELD EMISSION PROPERTIES OF DIAMOND-LIKE CARBON FILMS USING A TITANIUM INTERMEDIATE LAYER" JOURNAL OF PHYSICS D. APPLIED PHYSICS, IOP PUBLISHING, BRISTOL, GB, vol. 32, no. 14, 21 July 1999 (1999-07-21), pages 1570-1577, XP000919679 ISSN: 0022-3727
- FYTA M G ET AL: "Structure, stability, and stress properties of amorphous and nanostructured carbon films" THIN SOLID FILMS, ELSEVIER-SEQUOIA S.A. LAUSANNE, CH, vol. 482, no. 1-2, 22 June 2005 (2005-06-22), pages 56-62, XP004870477 ISSN: 0040-6090
- MARTIN P J ET AL: "ION-BEAM-DEPOSITED FILMS PRODUCED BY FILTERED ARC EVAPORATION" THIN SOLID FILMS, ELSEVIER-SEQUOIA S.A. LAUSANNE, CH, vol. 193 / 194, no. 1 / 2, 1 December 1990 (1990-12-01), pages 77-83, XP000168982 ISSN: 0040-6090
- DING X-Z ET AL: "Structural and mechanical properties of Ti-containing diamond-like carbon films deposited by filtered cathodic vacuum arc" PREPARATION AND CHARACTERIZATION, ELSEVIER SEQUOIA, NL, vol. 408, no. 1-2, 3 April 2002 (2002-04-03), pages 183-187, XP004351360 ISSN: 0040-6090

## Description

### Field of the invention

The present invention relates to the application of coatings in a vacuum, and particularly to an apparatus which generates a plasma of electrically conducting materials. The apparatus is used for carrying out a process which provides a substrate with a diamond-like carbon coating improving the hardness of such a substrate, cutting performance and wear resistance. Furthermore, the invention relates to drilling devices employed in routing, slitting, drilling, and like processes on printed circuit boards as well as for machinery of A1, Cu , etc., and nonferrous materials.

### Background of the invention

Coatings with a diamond-like carbon are known in the art.

WO 2004/083484 A1 describes the possibility of depositing a nanocrystalline diamond-like material by CVD techniques on the surface of substrates, in particular the Chemical vapour deposition techniques for obtaining these standard-like carbon layers on the surface of PCB-milling cutters.

A main problem for PCB-manufacture is a steady pressure on an increase in productivity and reduced costs with the machining of PCBs. Due to the extreme hardness of diamond, DLC coated milling cutters are also excellently suited for machining hard composite materials and extremely heat resistant high-Tg materials where the glass transition temperature (Tg) is 170° to 180°C.

US 5,435,900, US 6,663,755 and US 6,617,057 all to Vladimir I . Gorokhovsky describe the possibility of depositing coatings in a vacuum by filtered cathodic arc deposition in one single reaction chamber, wherein in a vacuum a plasma arc surrounded by a magnetic deflection system is in communication with a first plasma source and a coating chamber is used as an apparatus.

EP 1 186 683 B1 discloses the use of filtered arc carbon sources for providing a diamond-like carbon (DLC) layer on pieces used in the watch industry.

B. Schultrich et al., Vakuum in Forschung and Praxis, vol.10 no.1 pages 37-46 (1998) reports an in the coating apparatus comprising a plurality of modular chambers with several evaporators and cathodic arc vaporisation units which are preferably of the filtered arc depostion type.

Diamond coated (DLC) milling cutters for Printed Circuit Board (PCB) are superior to ordinary carbide tools over PCB milling due of the extremely abrasive materials used and are for example disclosed in US 5,653,812, where the DLC layer is obtained by CVD techniques.

In general, micro tools, in particular micro drills, end-mills, etc., become more and more important for micro electronics and micro techniques. Micro tools for micro machinery or, in general, micromechanical parts need high quality coatings with low roughness. Moreover, low temperature during deposition is often of importance. In comparison with macro tools, there are a number of new requirements for micro tool coatings properties and the way to produce coatings for micro tools, caused by ultra small dimensions of micro tools. In particular, a micro tool coating should be not only hard, with low friction, but also smooth and well controlled thickness. The typical dimension of cutting edges for micro tool or curvature of radii of "point" is lower than 1 µm. One of the main problems is the overheating of sharp edges and "points" of micro tools during deposition process. High temperature and "bias" during deposition is usually favorable for good adhesion of coating to a substrate. However, overheating is a major problem for micro tools. There is a high plasma density around a sharp "point", and high current (ion) density coming on the "trip" is the result which leads to overheating. The overheating of cutting edges, for example, results in loosing their mechanical properties.

It should be noted, that at present, on the market no coated micro tools, in particular, micro drills with diameter <0.2mm are known to the applicant.

### Objects of the invention

The trend in PCB milling cutters and drills to deeper drilled holes makes it increasingly difficult to obtain deeper holes (total length of drilling) as well as a good quality of holes. As a result the geometry of the substrate and the coating must be exactly matched to the application. Standard tools, e.g. the twister of rough coatings mainly used, cannot handle these loads and specification and are often unable to convert the machine output into cutting performance.

Therefore, one of the problems underlying the invention was to provide a further and a better process for coating drilling and cutting devices with diamond-like carbon layers which would enable longer life time of tools coated therewith and better quality holes. Reference is made to a process not in accordance with the invention for coating a substrate with a wear resistant layer on the basis of carbon comprising the steps of
i) providing a substrate containing a material which has an affinity for carbon
ii) ion bombardment of a surface of the substrate
iii) deposition of a metal layer on said surface by a filtered ion beam containing one or more metal ions selected from the group of Ti, W, Cr and mixtures thereof, whereas the metal layer is deposited on the substrate at a "bias" (voltage applied to the substrate) between 0- 100V
iv) ion-bombarding the coated surface
v) deposition of a carbon layer on the surface.

The process provides a DLC coating with a good adhesion on a substrate at low temperature, which is very hard (> 40 GPa, preferably 45-60 GPa, especially Hv=5130) which is self-lubricant and relatively thick and is deposited at low temperatures. Furthermore, the coating has preferably an Young's modulus of 400-700 GPa.

The term "affinity for carbon" means that the material is able form a thermodynamic stable compound and/or phase with carbon.

Preferably a heating step is carried out before step i), wherein the substrate is heated to 200°C-300°C during a minimum of 20 minutes.

The unexpected effects and hardness as well as the durability of the DLC layers may also be ascribed to the provision of an interface layer of titanium which provides a better adhesion of DLC on the surface at relatively low temperature (lower than 200°C, more preferred lower than 120°C, most preferred lower than 70°C). The partial overlap of the carbon and titanium layer due to the ion implantation technique used in the process provides additional strength and better adhesion of the two coatings on the surface of the substrate.

A sharpening of the edges of the substrate, e.g. of cutting edges as drills may be obtained, by additional ion bombardement for example with Ar ions prior to step iii).

Steps iv) and v) may be repeated several times to obtain thicker DLC layers on the surface, i.e. thicker than 1 micron (mkm).

An optional cooling step after the deposition of the metal layer is carried out, whereby the substrate coated with the metal, for example titanium layer is cooled down to less than 100°C, preferably less than 70°C. The cooling provides an even better adhesion of DLC on the metal surface. The metal may be one or more of Ti, W, Cr and mixtures (like alloys) thereof. For ease of lecture, in the following titanium is used but stands also as *pars pro toto* for the other metals and mixtures mentioned above.

The deposition of the metal is preferably carried out at temperatures of more than 200°C to obtain a good adhesion. The metal "interface" layer is deposited on the substrate at a "bias" (voltage applied to the substrate) between 0-100V. However, for an efficient adhesion of the deposited carbon a temperature of less than 70°C is required. The time for cooling down the substrate can be reduced to less than 10 minutes by an in-line arrangement. In-line arrangement in the context of the present invention means that each process step is carried out in a specific area/place, for example in a reaction chamber, which are located at different places, but arranged along a line one after the other.

The ion bombarding by noble gases, in particular Ar, of the coated surface eliminates impurities which may affect the adhesion of the carbon layer on the titanium layer and may be carried out several times, especially if several carbon deposition steps are to be carried out.

Moreover, at the optimum conditions, namely, bias voltage, current, type of ions and substrate, the ion bombardment increase the sharpness of the cuttings edges of tools and may be as explained in the foregoing additionally carried out prior to step iii).

Preferably, the substrate is a metal containing substrate, wherein the metal of the substrate is selected from the group of one or more of iron, chromium, vanadium, tungsten, molybdenum, nickel, niobium, tantalum, their alloys, carbides, oxides, borides, nitrides, titanides. Thereby any known tool, as cutters, drills etc. can be used as a substrate to harden and sharpen its surface or cutting edges. Preffered drills are micro-drills having a diameter of less than 0.3mm. An especially preferred material for the substrate is WC-Co containing 4% to 12% Co.

It is known to use DLC coating to improve surface hardness, friction coefficient and anti sticking of substrate. These features are considered to be the major DLC properties in order to improve the performance of a machinery tool or other functional parts in micro electro mechanical systems (MEMS). However, micro tools, with small dimensions, i.e. diameter of lower than 0.2mm for cylindrical substrates or a corresponding thickness of a substrate in general, (especially if it is made from polycrystalline materials) are very fragile. A major failure of such substrate is related to breakage through the development of cracks. The crack usually starts from a surface micro(nano) fracture and propagates through grain boundaries of the bulk material.

One of the advantages of the process is therefore the prevention of crack propagation, by "healing" surface micro (nano) cracks through the applied coating.

The ion beam treatment and the multilayer coating technology increases the unexpectedly elastic domain of a substrate and improves considerably, the breakage resistance and toughness of (micro)substrates. Moreover, it has surprisingly been observed that the effect of the coating on the elastic properties of any bulk material of a substrate is more and more pronounced when the diameter or thickness of a substrate becomes more and more smaller, at the limit when it is comparable with the grain size (e.g. of the crystals or amorphous crystal particles) of the material of a substrate, like a micro-tool. Therefore, in the process it is advantageous to grow a DLC coating not as hard as technically possible, but to provide a coating structure which "closes" micro (nano) cracks on the surface.

In further embodiments, the substrate is a silicon or a ceramic substrate, thus giving access to specific substrates and tools. In this case the substrate contains preferably oxides, nitrides, carbides, silicides, of one or more of iron, chrome, vanadium, tungsten, molybdenum, nickel, niobium, tantalum.

The cleaning step is preferably carried by ion beam sputtering, preferably in vacuum. It is understood that equivalent measures can be applied as well.

After the metal deposition, ion bombarding is carried out, preferably with noble gas ions, most preferably by argon ions. The temperature of the substrate during ion bombarding of the metal is kept preferably below 200°C, more preferred below 150°C, for example by using low energy ion gun with below 250V. Further parameters of the preferred low energy gun are an anode current of 3A to 10A, most preferred roughly 5A, a cathode current of 0A to 30A and a gas pressure of 10⁻² to 10⁻⁴ Torr. The cathode is preferably made from a tungsten filament and is based on the principle of a Hall accelerator.

The final deposition of carbon is carried out by a pulsed filtered arc ion beam containing essentially carbon ions. The frequency is preferably between 1Hz and 15Hz. The ion beam does in one embodiment not contain C-H compounds as in other techniques in the prior art. Therefore smooth C-H compounds and implantation products are not formed as in prior art techniques. Preferably, the coating is carried out at a temperature of less than 100°C, more preferred less than 70°C. Furthermore, the deposition is carried out with 70-140 eV. The cathode for the deposition of carbon is preferably a high density, low grain size, high pressure made cathode.

The pulsed mode of the arc discharge is very convenient to control film thickness by counting a discharge number.

The thickness of the carbon implantation zone is in the range of between 5 to 50 nanometer which has preferably a constant gradient in carbon atom concentration from 0 to 100%. It is understood that the carbon implantation can reach deeper in the substrates than the metal, for example titanium implantation and in the titanium layer, consequently both implantation zones have a certain overlap.

The total DLC layer on the surface of the substrate has thickness of 1 to more than 1000 nanometer, namely 1500 nanometer, thus enabling a variety of applications. More preferred is a thickness of from 400 to 700 nanometer. Preferably, the diamond-like carbon layer has an amorphous carbon matrix or an amorphous matrix with dimaond-nanoclusters. The term "nanocluster" is understood in the sense according to the description given in: "Raman spectroscopy of amorphous, nanostructured, diamond-like carbon, and nanodiamond" by A.C. Ferrari and J. Robertson in "Phil. Trans. R. Soc. Lond. A (2004) 362, 2477-2512.

The substrate has metal, especially a titanium, chromium or tungsten layer on a surface of the substrate and a layer of diamond-like carbon arranged on said metal layer, wherein the carbon layer and the metal layer are partially overlapping and the carbon layer has a gradient in carbon atom concentration from 0 to 100%.

The deposited thickness of the metal layer is preferably 50 to 250 nanometer.

The thickness of the diamond-like carbon layer is 20 to 1500 nanometer. More preferred is a thickness of 400 to 700 nanometer.

In preferred embodiments, the substrate is a drill, mill cutter, blade, etc.

Both, the filtered arc metal deposition and the filtered pulsed arc carbon deposition are preferably assisted by a low energy ion, for example produced by the above named preferred low energy ion gun. The deposition is carried out preferably below 70°C, which is enabled by the combination of the named deposition techniques with the low energy ion gun.

The roughness (Ra) is preferably below 30 nanometer.

The basic structure of the coating is amorphous in order to resist and inhibit of crack propagation perpendicular to the surface of the substrate. Optimum design of DLC coating, including micro structure, film thickness, hardness depends on the specific application intended.

Surprisingly, the process combines further the combination of different properties of carbon films in one single coating when, as described below, several carbon layers having each a different ratio of sp³/sp² carbon, are comprised within the coating. These "Multilayer structures" where each layer has a different sp³/sp² carbon ratio to inhibit even more efficiently crack propagation.

The final micro structure depends on the coating process as well as on the surface properties of a substrate, depending on a flat surface or "pointed" surface with sharp edges. It is even possible to have surface regions of a coated substrate which have different hardness, proportion, etc. due to a different local ratio of sp³/sp² carbon in these areas.

The problem underlying the invention is solved by an apparatus for the coating of substrates with diamond-like layers comprising a plurality of devices, namely:
i) a metal filtered arc ion source;
ii) a carbon ion filtered or non-pulsed filtered arc source, or a laser ablation carbon source;
iii) a lower than 330V energy ion gun of the Kaufman-type;
iv) an infrared heating device;
v) a cooling device
and wherein the single devices are arranged in-line each in a separate reaction chamber, characterized in that a sample holder is provided with a fixture adapted to hold a plurality of cylindrical or conical cutting tools, such as drills, fixed slony the length of their (rotational axes in parallel to an ion flux from the metal filtered ion source i), so as to expose their cutting edges to the ion flux.
The single devices are preferably arranged in-line, each in a separate reaction chamber. The above mentioned parameters for the several ion bombardments apply to the apparatus as well.

The in-line arrangement of the devices each in a single chamber allows inter alia a significant reduction of the time to cool down the substrate once coated with the metal.

For example, with respect to a one-chamber apparatus as used in prior art for similar techniques, the time for cooling down the metal/titanium coated substrate where the coating has to be carried out at more than 200°C is about one to two hours. In the in-line system according to the invention, where each device is arranged in a single chamber separated from the other chambers and linked by a moving device for the substrate to be coated being transported from one chamber to the next one, the time for cooling down the titanium coated substrate is about ten minutes.

This is an enormous time benefit for carrying out the process according to the invention.

Further, the in-line arrangement allows the use of a plurality of substrates, that is according to the sample holder used several hundreds or even thousands of smaller substrates to be coated at the same time, which increases dramatically the output of the process according to the invention.

The apparatus of the invention allows the use of several sample holders at the same time, which are preferably in the form of cassettes where the substrates, for example drills, cutting edges etc., are coated. In each chamber of the apparatus according to the invention, a sample holder is actually treated at the specific step of the process according to the invention.

This advantage increases the output of the process by a factor of ca. 500% with respect to a single reaction chamber according to the prior art where each process step has to be performed.

The metal source, in particular Ti, is a filtered arc ion source, in order to obtain a homogeneous adhesive layer when the cathode is made from the corresponding metals or alloys thereof. Furthermore, the metal source uses direct current metal deposition.

The carbon source is a pulsed, filtered or non filtered arc source, or laser ablation source to sputter graphite target, in order to create diamond like carbon coatings on substrates

The DLC coating according to the invention has preferably a Hardness H of H =45-60 GPa, (Hv= 5130) and an elastic modulus of 400-700 GPa

Carbon deposition occurs at 80 eV and with a floating potential. The amorphous carbon films is deposited at T <70°C, at variable arc pulse frequency of 1-15HZ . It is important to avoid high compressive stress to the hard DLC film during growth. The level of stress is controlled by varying the pulse frequency during deposition. Longer impulse >5Hz' yields more sp² "smooth" graphite like carbon phases, a lower frequency <1-5Hz, yields, more "hard" sp³-diamond like carbon phases. Therefore a coating containing different "carbon layers" with a different ratio of sp²/sp³ carbon is obtained. The stress can also be relaxed by varying the filtering level in the apparatus according to the invention.

In order to increase the deposition rate, a hydrocarbon (C₂H₂, CH₄, C₆H₆) containing gas, preferably pure acetylene, can be introduced into the vacuum chamber at a pressure of 10⁻³-10⁻⁵ Torr. The hydrocarbon molecules dissociation and ionization takes place in a carbon pulsed arc plasma flux. A small amount of hydrogen, liberated in the process is even advantageous to bind dangling bonds on the DLC film surface and on the interface of sp³ and sp² clusters. High ionization rate of plasma plum up to 98% and an extreme dense carbon particle flux leads to high nucleus growth rate on the substrate. The quasi-neutrality of plasma flow on a substrate allows to use dielectric substrates and a possibility to deposit DLC film characterized by homogeneous thickness on a substrate having a complex 3D surface geometry. In fact, increasing 3 times and more a deposition rate of DLC film by pulsed arc in presence of acetylene vapor at low pressure, maintaining almost the same DLC properties.

Pulse frequency variation, level of macro particle filtering and Hydrocarbon introduction in the deposition chamber can be done periodically during DLC deposition, making a quasi-layered DLC structure and leading to stress relaxation

The afore discussed variation of carbon arc pulse frequency, the level of macro particle filtering, the optimal hydrocarbon introduction in the deposition chamber during carbon deposition has an effect on the carbon sp³/sp² ratio, the density of the layer, etc. in the overall coating.

Therefore, a quasi multilayered structure of carbon films or layers which constitute the DLC coating with altering properties can be obtained by the process according to the invention.

The result is a basically amorphous carbon structure which is when more efficient to prevent crack propagation in the direction perpendicular to the substrate surface than a single homogeneous DLC layer.

The nucleation, growth and the fine structure of DLC coating depends on the substrate surface, in particular flat or sharp surface sites as well as incident angle of carbon ion flux on the substrate.

The ion gun is a lower than 300V ion gun of the Kaufman-type. Further parameters are named above in relation with the inventive processes.

Preferably, the bias during the carbon deposition is changed by sinus harmonic.

The substrate to be coated is preferably a metal containing substrate. Again, preferred features of the substrate are identical or similar to the preferred features named in relation with the afore described process.

The substrate is according to the geometry preferably arranged in an angle of <90°, most preferred parallel (i.e. 0°) with regard to the ion flux from the ion source, specifically in the case of cylindrical, elongated substrates like drills to be coated on a cutting edge.

Preferably, these cylindrical substrates are for example drills to be coated and the rotational axis is preferably parallel to the incoming ion flux so that only the edges of the cutting tools are coated, which offers an unprecedented advantage concerning the decrease of the amount of DLC to be used in order to obtain efficient drilling and cutting tools.

The metal of the substrate is selected from one or more of the following: steel, iron, vanadium, tungsten, cobalt, chrome, nickel, niobium, tantalum or their metal oxides, carbides, nitrides, silicides, titanides.

A key feature of the apparatus according to the invention is that if the cylindrical or conical substrates, like for example drills, are to be coated by the combination of ion implantation, ion mixing and of negatively biased surfaces in this system very hard DLC-layers for PCB milling application are provided.

Preferably, the metal source has its own separated system of coils to produce an axial magnetic field. In general, the metal source uses preferably round coils.

The process is exemplarily described in more detail with respect to the coating of drills without meant to be limiting.

The fixture of the substrate in a specific embodiment a plurality of drills includes a portion of the drills to be coated, an electric insulated spacer and electrically grounded shield. The fixture in the form of a cassette or any other suitable holder contains a plurality of single drills to be coated, usually several hundreds. The holder is arranged in a double rotation sample holder (planetary system). A loaded fixture is placed into a plasma deposition vacuum chamber and air in said chamber is evacuated. Gas is added to the vacuum chamber ion beam gun is ignited, causing the surface of the drills to be sputter-etched to remove residual contaminants and surface oxides and to activate the surface, and moreover, at optimum conditions to make the cutting edges sharper. Afterwards a titanium containing material layer, preferably pure titanium, is deposited by arc plasma deposition. This titanium containing material layer may be used an adhesion layer for subsequent deposition of DLC like carbon. The samples (i.e. the drills) are along their length fixed in parallel to the ion flux direction coming from the arc source where the cutting edges are directly exposed to the ion flux. This geometry preferably allows the increase of the input of the deposition of the machine for drill cutting, since a higher quantity of drill can be loaded in one charger of the machine. This geometry is preferred because the micro-drills have a conical shape where the functional cutting edge is the most important part to be coated.

In general, the present invention provides the following advantages:
- the multilayer structure of the coating, containing adhesion metal and amorphous carbon (DLC) obtained with the process according to the invention on a substrate has an excellent surface integrity, for example with a WC-Co material (adhesion). The coating covers all microcracks between the crystals of the material of the substrate on the surface of for example WC-Co where rupture can start to develop. Thus, the DLC obtained by the process according to the invention acts like surface "glue",
- the DLC coating obtained by the apparatus according to present invention has an extremely efficient chip evacuation (debris of cutting materials can be evacuated very fast (since DLC has very low friction coefficient). Together with debris, temperature is carried away from a cutting point. This is of high importance for deep hole PCB drilling in order to get an exellent surface quality of the hole during high speed drilling in PCB (printed circuit board) of more than 150 krpm,
- the coating has a low friction coefficient, which allows a very high efficiency of chip evacuation during drilling,
- the coating increases the overall toughness of a coated substrate. Bending tests carried out on a WC-Co substrate (*vide supra*) showed an increase of 10-20% of the critical load for 0.105mm and 0.05mm coated drills,
- the coating for micro tools improves not only the surface, but also the bulk properties of the overall system (coated substrate), due to the low dimensions of the micro tools, and
- the coating improves the critical bending load of a micro tool like a WC-Co micro drill by a factor of 17-23% (critical load for bending rupture for 0.1mm WC-Co drill without coating is 490mN and with coating is 550mN, the rupture happened at the same bending distance 180 microns).
- the coating increases the service life time of a micro tool for a machinery of the factor 5-10 with regard to non-coated drills by maintaining high quality of a hole.

It is of importance to note that there is an optimum in the coating specifications correlated with substrate properties, namely, the optimum thickness, hardness, elasticity, related to the microstructure of the coating are in correlation with diameter of a tool, its grain size, etc. In general, a thicker coating has a more pronounced effect to the elasticity of the bulk substrate. However, there is an upper limit of coating thickness for cutting micro tools related to a degradation of a sharpness of cutting edges when the coating thickness increase.

The invention is explained in still further details with reference to the figures. It is understood that the explanation in the figure are by no means a limitation of the scope of the invention.
- Fig. 1: shows a schematic representation of an apparatus according to the invention with different chambers.
- Fig. 2: shows a detailed side view of a drill to be coated in the chamber with an arc ion source.

- Fig. 3a: shows a detailed sectional view of an apparatus according to the prior art.
- Fig. 3b: shows a front view of an apparatus according to the prior art.
- Fig. 3c: shows a side view of an apparatus according to the prior art.
- Fig. 4: shows another preferred embodiment of an inventive apparatus.
- Fig. 5: shows a comparison of breakage resistance in bending (flexion) tests on a coated and non coated microdrill.

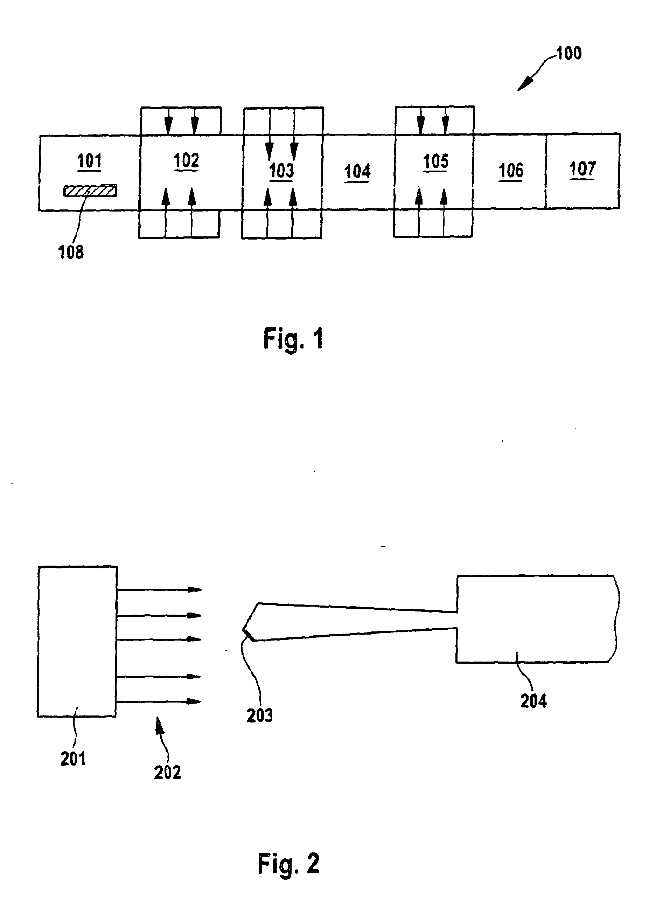

Fig. 1 shows an apparatus (100) according to the invention which has several reaction chambers 101, 102, 103, 104, 105, 106 and 107.

A substrate 108 or a plurality of substrates 108, for example drills, is placed on a sample holder in chamber 101. The sample holder is arranged in that way that it is in the position to move from chamber 101 to chamber 107 and the drills are fixed on the sample holder in such a way that they are perpendicular to the direction of the movement. Chamber 101 is termed as "loading chamber".

Thus, in chamber 101 the charging of the sample holder 108 with the drills which are not represented in Fig. 1 is carried out.

After being charged with a plurality of samples (identical or different ones), the sample holder 108 moves to the ion surface polishing chamber 102 which is carried out as indicated by the arrows, a sputter cleaning is applied to further obtain the heating at a temperature of 250°C by means of argon ions.

After the ion surface polishing, sputter cleaning and heating, the sample holder 108 moves to the first metal deposition chamber 103.

In the metal deposition chamber 103 the deposition of a metal layer, for example titanium (adhesion layer) from a non represented filtered arc source and beam mixing by ion gun is carried out.

The arc ion source is represented by the arrows which represent schematically the ion beam.

The deposition can occur on both sides of the substrate. After being coated with a first metal layer, the sample holder 108 moves to a cooling chamber 104 where the sample holder 108 and the drills or substrates to be coated are cooled down to around 100°C.

After passing the cooling chamber 104 the sample holder moves further to chamber 105 where the carbon deposition/ion beam mixing takes place. The arrows show also a schematic representation of the carbon ion beams.

After being coated with carbon, the sample holder 108 moves further to chambers 106 and 107 where the samples can be recovered.

As already explained in the foregoing, one of the main advantages of the apparatus according to the invention is that during the process, in each chamber one cassette containing a plurality of substrates to be coated is present. This allows for example according to the specific embodiment of Fig. 1 the parallel processing of seven substrate holders at the same time, i.e. several hundreds of different or identical substrate edges can be continuously coated.

Fig. 2 shows in detail a sectional view of a sample 204 which is a drill (200) made for example from WC-Co alloy which is based in front of an arc ion source 201.

The ion beams coming from the source of deposition are indicated as arrows 202. The ions in the ion beam 202 will arrive especially at the section 203, i.e. the front part of the drills to be coated and will provide a thicker coating on the front part of the drill with respect to the other non perpendicular arranged parts of the drills.

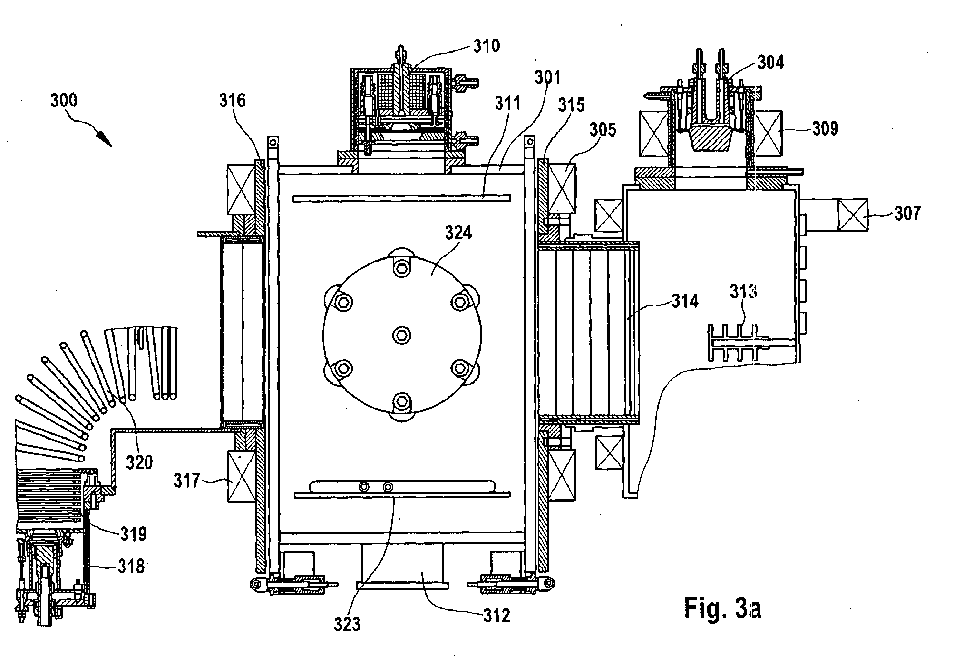

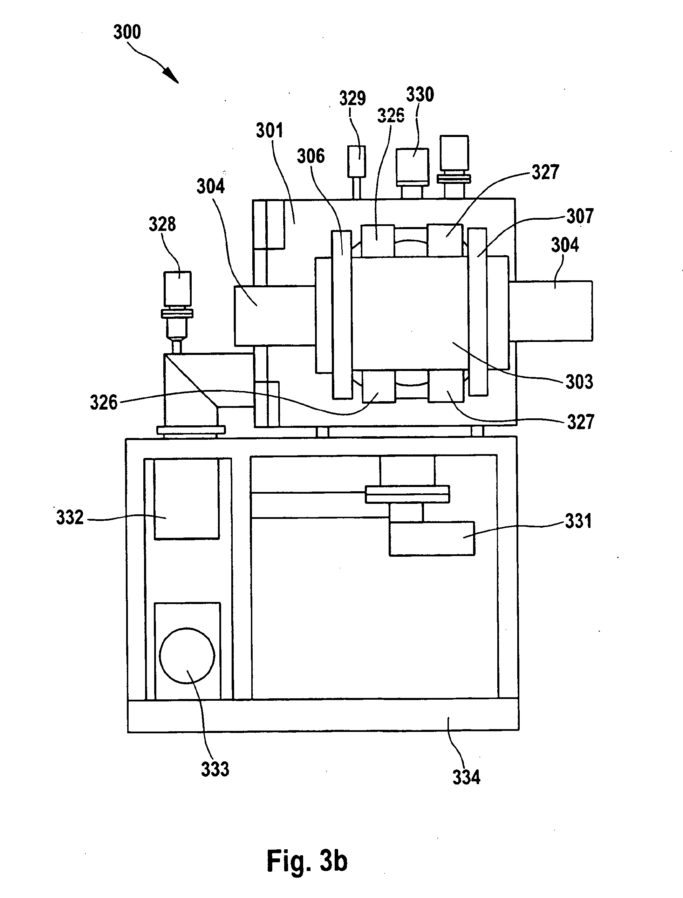

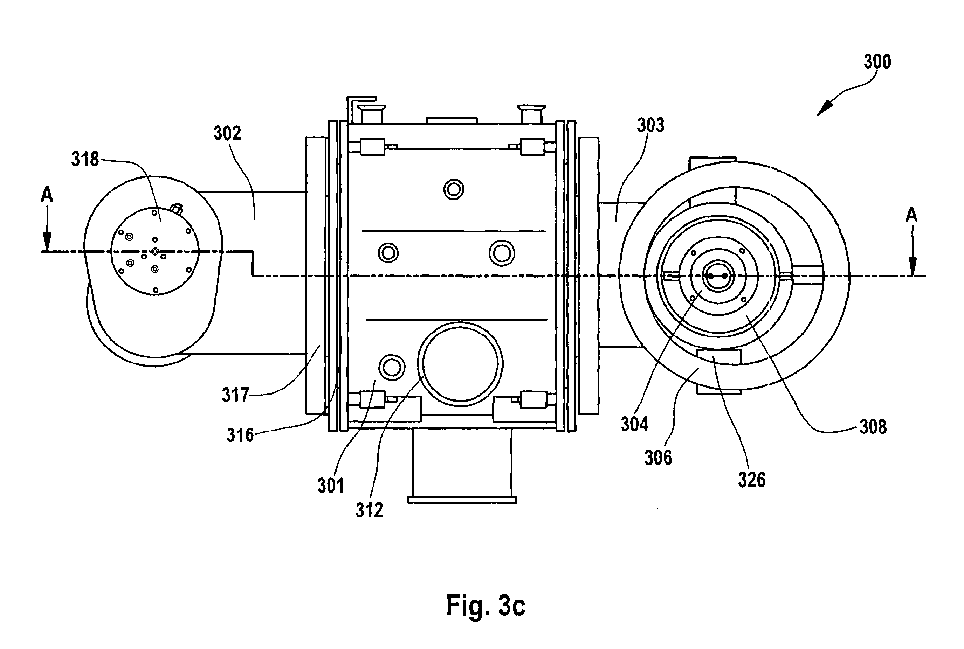

Fig. 3a to 3c show a detailed sectional view of an apparatus 300 according to the prior art as a one chamber apparatus.

It is possible to use a batch system apparatus for the purpose of the process and gives similar results, however, as explained in the foregoing, the output is reduced compared to the in-line system according to the invention.

The apparatus 300 consists of a vacuum chamber 301 with a pulsed carbon plasma system 302 and a metal plasma system 303 as described in the foregoing. The metal arc source 304 and a focusing solenoid 305 are also arranged at the chamber 301. further solenoids 306, 307, 308 and 309 are used for the stabilization of the system. A low energy ion gun 310 is arranged on one side of the vacuum chamber 301 as well, and shields 311, 330 and a vacuum pump system 312. Further systems 313 and 314 are arranged for the trapping of macroparticles which may result from the process of the invention. Vacuum doors 315 and 316 provide access to the camber 301. A further focusing solenoid 317 is also arranged in the vicinity of the vacuum door 316. A carbon plasma arc source 318 with an additional anode 319 for the pulsed arc carbon source provide the device for the carbon coating of a substrate together with a magnetic filter system 320 for the source 318. An infrared heater 323 is arranged opposite to the low energy ion gun 310. The sample holder 324 has a so-called double rotated planetary system. Furthers solenoids 326 and 327 for the plasma deviation are also provided together with vacuum meters 328 and 329. The rotation is controlled by the device 331. A turbopump 332 a further pump 333 and a support 334 are further details of the apparatus 300.

### Example 1

Drills (diameter 0.1mm) containing a basic alloy of tungsten carbide containing about 5% Cobalt were coated with a titanium/DLC layer (Ti: 0,1 µm , DLC: 0,6 µm) according to the process of the present invention.

After having been coated, the drills were removed from the apparatus and subjected to a drilling test.

The drilling tests were carried out by drilling holes for a diameter of 0.1 mm drills at a rotation speed of 300.000 rotations per minute, 220.000 and 160.000 rotations per minute respectively in a standard PCB.

### Comparisons were made with regard to non-coated drills

The average increase in the 0.1 mm drills of the length of the drilling is in the factor of 8.

The quality of the hole was determined by means of electron microscopy in accordance with the standard given on the following web site http:// www.uniontool.co.jp /English/ tech_02.html.

In further preferred embodiments, the thickness of the coating and of the diameter of the drill were optimized. This was determined as relationship between the diameter and Youngs modulus (elasticity modulus), i.e. the force applied to break the drill. For a drill with a diameter of 0.1 mm, the optimum DLC' layer thickness was between 0.5 to 0.8 mm to obtain an elasticity modulus of 400-600 GPa for a hardness of 45-60 GPa.

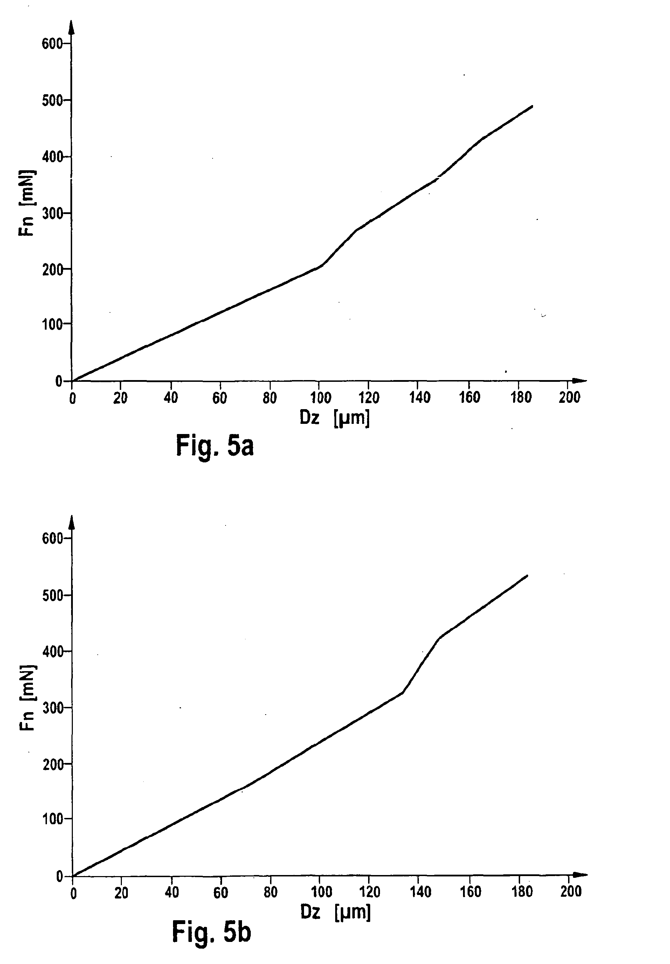

Figure 5 shows the results of a bending test between a coated (figure 5b) and a non-coated (figure 5a) drill. The diameter of the drill (the core) was 105 µm. The thickness of the Ti layer was 0,2 µm and the the thickness of the DLC layer 0,6 µm. The abscissa shows the applied force in mN and the ordinate the displacement (the bending compared to the normal state) in µm.

The results showed that the critical load needed to break the coated drills is about 15-20% higher, than for uncoated drills. Values were 551 mN applied force until break for the coated (Fig. 5b) and 481 mN for the non-coated (Fig. 5a) drill.

### Test Parameters

To perform the tests, the indenter with spherical end was positioned at the end of the drill using a video microscope. The progressive force "loading" was applied (about 20 mN/sec) until the fracture of the drill. During this time the applied force as well as the vertical displacement of the indenter was recorded on a function of time. As shown in Fig. 5, at the beginning, at a low value of loading, there is a linear dependence between applied forces and displacement, corresponding to an elastic domain of deformation of the substrate. Its slope and the length depends on elastic properties of the substrate. Then, after an increase in loading, a non linear range corresponding to a work hardening of a substrate material was observed. The breakage occurs after at certain value corresponding to plastic deformation. Test atmosphere: Air; temperature: 24°C; humidity: 30%. It is important to note that the conditions of tests, in particular, a axial fixation of drills (grooves position) relative to the axe of applied forces, should be the same for all drills under the tests.

Moreover based on this type a flexion tests, a new method for the quality control of coated drill can be provided. In principle it is sufficient to apply a loading and to observe only the elastic part during flexion. In fact, there is a difference in a slope of a plot of applied forces vs flexion between coated and non coated drills. The value of this slope is a good indicator for the coating effect.

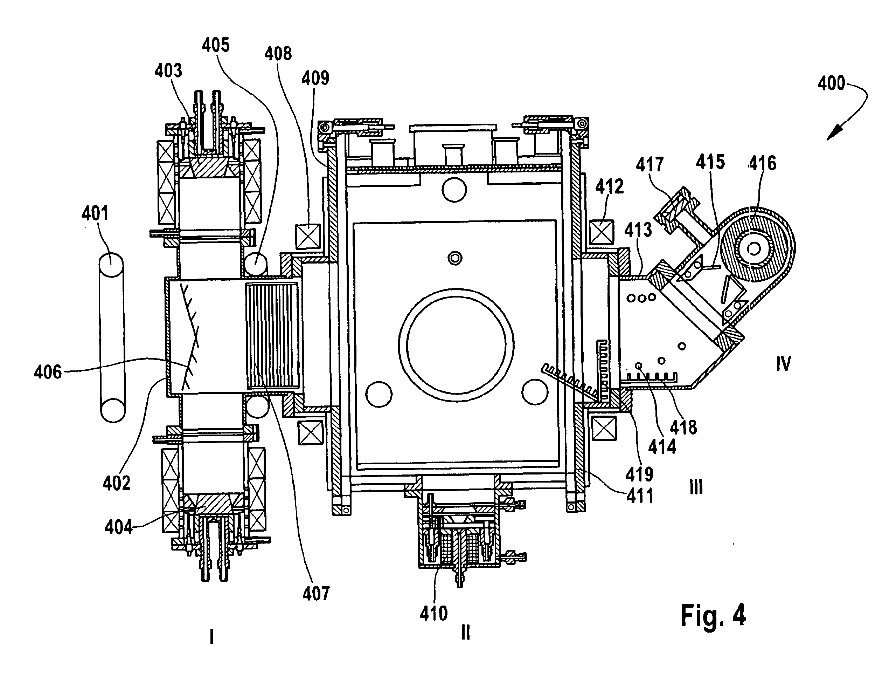

In Fig. 4, another preferred embodiment of the invention is shown schematically. The shown apparatus 400 for the coating of substrates provides three main parts, which are signed by roman numerals, which refer respectively to the following parts. I: filtered arc metal ion source, II: pulsed filtered arc (laser ignition) carbon deposition, III: low energy ion gun. These parts are explained in the following using the above named roman numerals.

The filtered metal ion source (I) comprises a metal shielding 402, metal plasma arc sources 403, 404 a system of electromagnetic coils 401, 405, 408, 412 and macro particle traps 406, 407. The metal plasma sources 403, 404 have its own system of coils to produce an axial magnetic field. There are three independent systems of coils and the magnetic field results from the superposition of the coils 401, 405, 408, 412 and the metal plasma sources 403, 404. This allows a fine adjustment of the filter system performance not only by current variation of the current in the coils 401, 405, 408, 412, but also by varying the position of the distance of the coils 401, 405, 408, 412. Means for varying the position of the coils 401, 405, 408, 412 are a generally preferred feature of the invention. The systems of the coils 401, 405, together with the coils 408, 412, form a system similar to a Helmholtz coils system. The coils 408, 412 allow a controlling of the plasma flow inside of the vacuum chamber, which is confined by the metal shielding 402, such that it is possible to achieve a plasma concentration close to the center of the chamber or such that a broad homogeneous plasma distribution inside of a chamber can be achieved. The plasma control allows a good quality deposition of ions on complicated 3D-parts. Moreover, the magnetic field inside of the chamber prevents a recombination of ions in the used plasma volume and results in a better quality of the deposited films. The macro particle traps 406, 407 are insolated from the chamber, providing an additional possibility to control the plasma flow. The coils 401, 405, 408, 412 are round, which provides better electrical fields. Therefore, the round form of the coils is a generally preferred feature of the invention. Preferably a number of additional coils are provided for a better control of the plasma flow. The system of coils allows a considerable increase of the number of objects to be coated in one charge by using only a double or even a single rotation sample holder.

An other important detail allowing an increased throughput is that the objects to be coated, like drills, are placed in the chamber in parallel to the plasma flux, keeping a good quality of the coating. A classical principle for metal macro particles filtering is used based on a 90° deviation in a magnetic field. There can be single or double or even triple 90° sources joint in one exit to the deposition chamber. The schema presents double sources. It can be used to double a metal ion flux density in the deposition chamber or to deposit a combination of different metals, like Ti, A1, Cr, W, in the present of reactive or non reactive gas, like nitrogen, ethylene, acetylene, methane, Ar, or Xe.

### The pulsed arc carbon source (II) for a large area deposition:

A pulsed arc plasma technique to deposit DLC films on a large area has been developed to deposit DLC films in vacuum at a low temperature in two options. In general, the pulsed carbon plasma is formed in vacuum as a result of a short-time electrical arc discharge between a water cooled graphite cathode and an anode of the plasma source. The Plasma source functioning is based on evaporation and ionization of the material ejected from cathode spots while an arc discharge takes a place. The capacity of the main capacitor bank magazine is about 2500 µF; initial voltage lies in the range from 200 V to 400 V. The plasma source accelerates plasma towards the substrate. The pulsed plasma is formed in the vacuum as a result of a short-time electrical arc discharge between a water cooled graphite cathode and a ring-like anode of the plasma source. To ignite the arc discharge in vacuum it is necessary to create precursor density plasma. For this purpose, the plasma source is equipped with a special ignition system. There are two options (IIa and IIb):

### Pulsed arc carbon source with deflection and electrical ignition (IIa):

The main element of the technique is a Hall-type pulsed plasma source assigned to produce a carbon plasma flow directed to substrate as a result of the electroerosion of the graphite cathode. An ignition is provided by an insulator rotation inside the carbon ring anode in the contact that is placed around the cathode. Herein, a "point" carbon source with a round cathode of about 35 mm diameter is used. The main discharge voltage is 200 to 400V, the ignition discharge voltage is about 600V. The discharge impulse repetition rate is 1 to 10Hz. The deflection system is arranged at the pulsed arc source in order to cover a large area of deposition, namely up to 150mm height. Moreover, in order to cover a larger area of deposition, namely 300mm and slightly more, two sources are arranged vertically, one above another. The two sources work in parallel, with the frequency between 3-10 Hz.

### Laser ignition system (IIb):

In general, Laser arc system for carbon deposition were proposed and developed by Scheibe (see US-Patent 6,231,956).
The system used herein provides some important differences. In particular, the system provides a potential between a cathode 416 and an anode 415 of 300-320 V and it is connected with a battery providing a capacity of 2000 microF. The Laser beam is directed via a window 417 to the cathode surface 416. Due to ablation, conductivity in space between the cathode 416 and the anode 415 increases and a discharge current increases very fast. An intensive evaporation of carbon ions occurs from the "cathode spot" of the graphite cathode and also increases rapidly. The carbon flux is highly ionised. The discharge time is about 10 microseconds. This time is determined by a capacity and the resistance of the elements connected to the discharge "chain". After the pulse end, the laser spot moves about 1mm vertically. The graphite cathode has a cylindrical shape and it turns around its axe.

### Adjustable carbon macro particle filter (III):

The filter does not provide a classical 90° bending filter (or twice bended in 90°). In fact, for practical reason, it is not necessarily to eliminate all carbon macro particles, since they are useful in improving the properties of the DLC coating. But, it is of importance to control it. The first important new solution is that the filter turns carbon plasma on about 45° and provides vertical conductive copper wires 414, isolated from the chamber ground 13 and connected outside such that a rectangular spiral unit of a coil is provided. The same current passes through this coil like the main discharge current. The cathode and the anode are not galvanically connected with the chamber ground. The cathode is connected directly to the main capacity, and the anode is connected via the solenoid of the filter. There are also macro particles traps 418, 419, which are isolated from the wall ground. A part of the trap 419 is mobile and can be fixed at different positions in order to stop different portions of macro particles. Hence, secondly, the filter allows a controlling of the macro particle filtering level. It can be named as an "adjustable carbon macro particle filter". This design allows working both in a non-filtered and a filtered adjustable mode.
This provides a very high efficiency separator having a compromised solution for industrial application.

### Low energy ion gun (IV):

It is of importance to apply merely low energy for an ion bombardment of the surface such that overheating of substrate surfaces is avoided. However, the low energy does not influence the efficiency of the ion bombardment. It is based on the principle of a Hall accelerator (Energy: 50-200eV, Anode current: 5A, Cathode current: 0-30 A, Gas pressure: 10⁻¹ to 10⁻⁵ torr). The cathode is made from a W-filament. The gun is widely open with a conic aperture (see fig. 4). It allows that the ion flux generated by this gun covers all useful plasma volume in the deposition chamber (see fig. 4). It means that all substrates are under ion bombardment during the ion gun is working. This increases the efficiency of the ion beam treatment. The low energy ion gun is used for surface cleaning, polishing, ion beam mixing and ion beam assisted deposition.

## Claims

1. Apparatus for the coating of substrates with diamond-like layers comprising a plurality of devices, namely:
i) a metal filtered arc ion source
ii) a carbon ion pulsed filtered or non-filtered arc source, or a laser ablation carbon source
iii) a lower than 300V energy ion gun of the Kaufmann-type,
iv) an infrared heating device
v) a cooling device.
and wherein the single devices are in-line each in a separate reaction chamber,
**characterized in that** a sample holder is provided with a fixture adapted to hold a plurality of cylindrical or conical cutting tools, such as drills, fixed along the length of their rotational axes in parallel to an ion flux from the metal filtered ion source i), so as to expose their cutting edges to the ion flux.

## Patentansprüche

1. Apparat zum Beschichten von Substraten mit diamantartigen Schichten, umfassend eine Vielzahl von Vorrichtungen, nämlich
i) eine gefilterte Lichtbogen-Metallionenquelle
ii) eine mit Kohlenstoffionen gepulste, gefilterte oder nicht gefilterte Lichtbogenquelle oder eine Laserablations-Kohlenstoffquelle
iii) eine Ionenkanone vom Kaufmann-Typ mit einer Energie von weniger als 300 V
iv) eine Infrarotheizvorrichtung
v) eine Kühlvorrichtung,
und wobei die einzelnen Vorrichtungen sich in einer Reihe jeweils in einer separaten Reaktionskammer befinden,
**dadurch gekennzeichnet, dass** ein Probenhalter mit einer Haltevorrichtung versehen ist, die zum Halten einer Vielzahl zylindrischer oder konischer Schneidwerkzeuge, wie zum Beispiel Bohrer geeignet ist, die längs zu ihren Rotationsachsen parallel zu einem Ionenfluss aus der gefilterten Metallionenquelle i) so befestigt sind, dass ihre Schneidkanten dem Ionenstrahl ausgesetzt sind.

## Revendications

1. Appareil pour l'enduction de substrats avec des couches de type diamant comprenant une pluralité de dispositifs, à savoir:
i) une source d'ions à arc filtré métalliques,
ii) une source à arc filtré ou non filtré à impulsions d'ions carbone, ou une source de carbone à ablation par laser,
iii) un canon ionique à énergie inférieure à 300 V du type Kaufmann,
iv) un dispositif de chauffage à infrarouge,
v) un dispositif de refroidissement;
et dans lequel les dispositifs uniques sont en ligne chacun dans une chambre réactionnelle séparée,
**caractérisé en ce qu'**un support d'échantillon est pourvu d'un dispositif de serrage adapté à tenir une pluralité d'outils de découpe cylindriques ou coniques, tels que des forets, fixés le long de la longueur de leurs axes de rotation en parallèle à un flux d'ions provenant de la source d'ions filtrés métalliques i) de manière à exposer leurs bords de coupe au flux d'ions.
